(19)

Europäisches
Patentamt
European
Patent Office
Office européen
des brevets

(11) **EP 4 290 463 B1**

(12) **EUROPEAN PATENT SPECIFICATION**

(45) Date of publication and mention
of the grant of the patent:
**06.05.2026 Bulletin 2026/19**

(21) Application number: **23178359.8**

(22) Date of filing: **09.06.2023**

(51) International Patent Classification (IPC):
*G06T 15/10* (2011.01)        *G06T 17/05* (2011.01)
*G06T 19/20* (2011.01)

(52) Cooperative Patent Classification (CPC):
**G06T 15/10; G06T 17/05; G06T 19/20;**
G06T 2219/2016

(54) **METHOD FOR VISUALISING A 3D INFRASTRUCTURE DESIGN MODEL IN A PLANAR COORDINATE SYSTEM ON AN ELLIPSOID**

VERFAHREN ZUR VISUALISIERUNG EINES 3D-INFRASTRUKTURDESIGNMODELLS IN EINEM PLANAREN KOORDINATENSYSTEM AUF EINEM ELLIPSOID

PROCÉDÉ DE VISUALISATION D'UN MODÈLE DE CONCEPTION D'INFRASTRUCTURE 3D DANS UN SYSTÈME DE COORDONNÉES PLAN SUR UN ELLIPSOIDE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **09.06.2022 FI 20225502**

(43) Date of publication of application:
**13.12.2023 Bulletin 2023/50**

(73) Proprietor: **Vektorio Oy**
**33100 Tampere (FI)**

(72) Inventor: **Vesanen, Juha**
**33100 Tampere (FI)**

(74) Representative: **Kolster Oy Ab**
**Salmisaarenaukio 1**
**P.O. Box 204**
**00181 Helsinki (FI)**

(56) References cited:
**US-A1- 2020 202 049     US-A1- 2021 375 033**
**US-A1- 2022 076 503**

EP 4 290 463 B1

**Description**

FIELD OF THE INVENTION

The present invention relates to computer graphics, especially to visualisation of three-dimensional models/designs on an ellipsoidal coordinate system such as World Geodetic System (WGS).

BACKGROUND OF THE INVENTION

Three-dimensional (3D) visualisation is an important developing computing technology essential for many specific industries, including construction, infrastructure building and design. The present invention relates to visualisation of 3D infrastructure design models originating from various design processes and utilising computer graphics visualise such 3D infrastructure design models on an ellipsoid using an ellipsoidal coordinate system such as the WGS84.
Patent application US2022/076503A1 discloses a method for visualizing a three-dimensional model in an interactive editing workflow.

BRIEF DESCRIPTION OF THE INVENTION

An object of the present invention to provide a method and an apparatus for implementing the method so as to overcome the above problems. The objects of the invention are achieved by a method and an arrangement which are characterized by what is stated in the independent claims. The preferred embodiments of the invention are disclosed in the dependent claims.
The invention is based on the idea carrying out transformations of 3D infrastructure design models of objects such as models of buildings or infrastructure or some other object, which are typically designed in planar coordinate systems i.e., having axis orthogonal against each other. Drawing 3D infrastructure design models, especially with substantial dimensions, on an ellipsoid coordinate system such as the WGS can cause inaccuracies when multiple 3D infrastructure design models are drawn.
An advantage of the method and arrangement of the invention is that multiple 3D infrastructure design models can be drawn in the same view accurately. The 3D infrastructure design models may be originally designed in different planar coordinate systems. They may be designed e.g. by Computer Aided Design tools used in different fields of technology such as infrastructure design or building design or they might be point clouds captured with 3D scanners from real environments. For example, each country or city might utilize many different planar coordinate systems in their design processes. There are large databases available of such coordinate systems, for example one originally created by European Petroleum Survey Group (EPSG). Correct visualisation of multiple objects is essential for building industry, which by nature needs to integrate design from multiple sources. Furthermore, the 3D infrastructure design models used for designing an infrastructure project typically includes 3D infrastructure design models in very different scales.

BRIEF DESCRIPTION OF THE DRAWINGS

In the following the invention will be described in greater detail by means of preferred embodiments with reference to the attached drawings, in which:

Figures 1a, 1b and 1c illustrate coordinate systems;
Figures 2a and 2b is illustrate a camera view on the surface on an ellipsoid;
Figure 2c illustrates a situation when a camera forward vector is pointed above horizon of an ellipsoid;
Figure 3 illustrates 3D infrastructure design models of objects and their translated versions in their planar cartesian coordinates;
Figure 4 illustrates 3D infrastructure design models of objects and placed on the surface of an ellipsoid;
Figure 5 illustrates a reference frame place on the surface of an ellipsoid;
Figure 6 illustrates an S-curve, which may be used in correcting the camera target point;
Figure 7 illustrates a view with exemplary 3D infrastructure design models on the surface of the Earth created by different kinds of tools and methods:

Figure 8 illustrates a process flow diagram illustrating an embodiment of a method for visualising a 3D infrastructure design model in a planar coordinate system on an ellipsoid;
Figure 9 illustrates a block diagram of an example computing apparatus in accordance with various embodiments;

DETAILED DESCRIPTION OF THE INVENTION

In the following, different exemplifying embodiments will be described using, as an example of the method for visualising of three-dimensional models/designs on an ellipsoidal coordinate system.

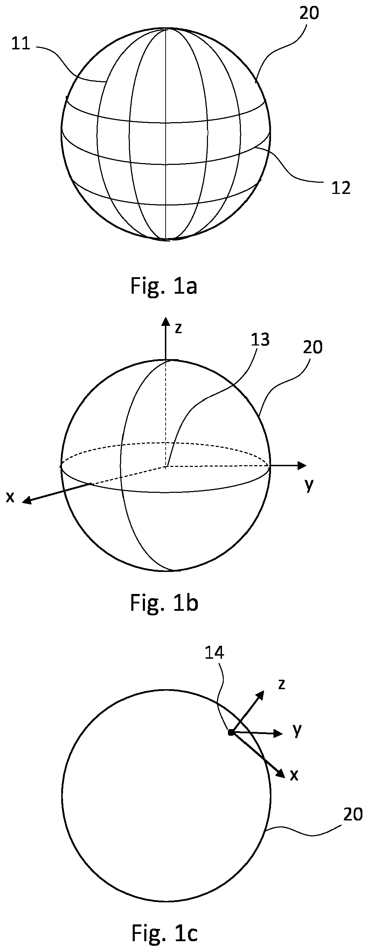

Figure 1a is illustrating an ellipsoid 20 with ellipsoidal cartographic coordinated system with lines showing longitudes 11 and latitudes 12.

Figure 1b is illustrating an ellipsoid 20 with an ellipsoidal cartesian coordinate system, wherein origin of the coordinate system is located at center 13 of the ellipsoid 20. Earth-centered, Earth-fixed coordinate system (ECEF) is an example of a cartesian coordinate system that represents locations in vicinity of the Earth (including its surface, interior, atmosphere, and surrounding outer space) as x, y, and z measurements from its center of mass. The z-axis is in the direction of the rotational axis of the ellipsoid of revolution,

Figure 1c illustrates a planar coordinate system at a point 14 on the surface of the ellipsoid 20. The axis of a planar coordinate system are typically oriented so that z-axis is oriented in parallel with the normal of the surface at the point in question, here point 14.

According to an embodiment of the invention there is a computer implemented method for visualising a 3D infrastructure design model in a planar coordinate system on an ellipsoid, where at least one 3D infrastructure design model is selected from a group of 3D infrastructure design models. The 3D infrastructure design models may be defined using design tools from different fields of technology such as infrastructure design or building design, and they are typically defined in planar cartesian coordinates. The 3D infrastructure design models may also be point clouds captured with 3D scanners from real environments. Original centre-points of the selected 3D infrastructure design models are stored to be used later in the procedure. The 3D infrastructure design models are translated so that their centre-points will be at the origin in the planar cartesian coordinates of the 3D infrastructure design models, correspondingly. A camera target point is determined in ellipsoid cartographic coordinates to a common centre-point of the 3D infrastructure design models in the ellipsoid cartographic coordinates. The common centre-point may be calculated e.g. as a point wherein a sum of distances to said 3D infrastructure design models has a minimum or it can be a centre-point of the 3D infrastructure design model that has the shortest distance to said 3D infrastructure design models or by some other way to select a point in proximity of said 3D infrastructure design models. The camera target point is converted from the ellipsoid cartographic coordinates to the planar cartesian coordinates. Transformation between ellipsoid to planar coordinate system is done by utilizing the generally available coordinate system definitions found for example in the European Petroleum Survey Group dataset. Unit axes will be calculated for the planar cartesian coordinates of said 3D infrastructure design models. The unit axes can be calculated by adding unit vectors on each axis to the planar cartesian coordinates:

$$
\begin{aligned}
unit_x &= TP_{PCS} + (1,0,0) \\
unit_y &= TP_{PCS} + (0,1,0) \\
unit_z &= TP_{PCS} + (0,0,1)
\end{aligned}
\qquad \text{Eq. 1}
$$

, where

$unit_{x,y,z}$=unit axes in x,y,z dimensions
$TP_{PCS}$ = camera target point in the planar cartesian coordinates.

The unit axes will be then converted to ellipsoid cartesian coordinates. It is essential to the invention that the unit axes are calculated in the planar cartesian coordinates and converted to the ellipsoid cartesian coordinates. A reference frame will be created using the camera target point in the ellipsoid cartesian coordinates and said unit axes. Said 3D infrastructure design models will be then transformed on the ellipsoid using the reference frame and the original (stored) non-translated centre-points of said 3D infrastructure design models. The 3D infrastructure design models will then be drawn on a graphics display.

According to another embodiment of the invention, the ellipsoid is WGS84 ellipsoid, which is widely used in cartographic systems.

According to another embodiment of the invention said camera target is determined by calculating the intersection point of the camera forward vector and the ellipsoid surface; and if the camera forward vector does not intersect with the ellipsoid surface, then the camera target point is interpolated between previous camera target point and the intersection point of the camera forward vector and the ellipsoid surface. The interpolation may be e.g. linear interpolation so that a T-value may be used the blend between the previous camera target point and a new camera target point derived from said intersection point, as is done in Equation 2.

$$TP = (1 - T) * pTP + T * ICFV \qquad \text{Eq. 2}$$

$$T = 1 - (\min(\alpha, AL) \, / \, AL) \qquad \text{Eq. 3}$$

, where

> $TP$ = camera target point (vector),
> $\alpha$ = camera tilt angle with respect to normal of the ellipsoid surface
> $ICFV$ = intersection point of the camera forward vector and the ellipsoid surface (vector)
> $pTP$ = previous camera target point (vector)
> $AL$ = angle limit

Be blending the point given by the camera forward vector 32 and the previous camera target point, the Equation 2 guides the next camera target point so that it will not raise too far in the horizon of the surface or too high with respect to the surface of the ellipsoid. The smaller the camera tilt angle is the stronger is the weight (T-value) on the previous camera target point. The T value may be derived from the camera tilt angle, but it may be also limited so that the camera forward vector 32 cannot point essentially above the horizon of an ellipsoid 20 or a limited angle AL. The camera tilt angle may be limited in various embodiments of the invention for practical implementations. The limited angle AL may be e.g. 40, 60 or 90 degrees or some other angle.

According to another embodiment of the invention there is a method wherein the camera tilt angle is corrected using a S-curve. The correction is performed to provide a smooth transition when the direction of the camera reaches the limits set to it. The curve may be calculated for example by a sigmoid function such as a logistics function or by a smoothstep function as given in Equation 4.

$$T_S(x) = \begin{cases} 0, & x \leq 0 \\ 3x^2 - 2x^2, & 0 \leq x \leq 1 \\ 1, & x \geq 1 \end{cases} \qquad \text{Eq. 4}$$

, where

> $T_S$ = corrected T value
> $x$ = T value based on camera tilt angle

The example of Equation 4 is a polynomial of third order, but the function can be also some other monotonically increasing function also. The relevant feature of such function is that it has zero 1st- and 2nd-order derivatives at the edges of the slope, in this example when x=0 and x=1. The S-curve may be implemented by other functions which introduce a graceful transition from level 0 to level 1. The S-curve may also be implemented as a pre-calculated look-up table.

According to another embodiment of the invention the camera target point is stored at any point creating the camera view including the 3D infrastructure design models. When determining the camera target point to be used in the next view, the stored previous camera target point and calculated camera tilt angle will be used to determine the camera target point so that the change can be limited.

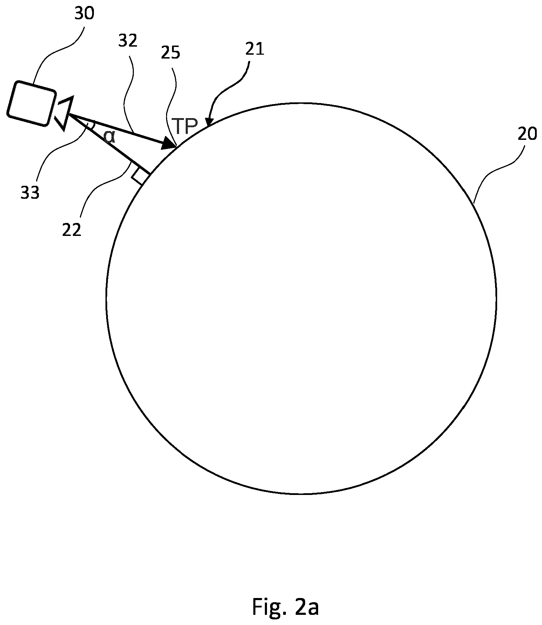

Referring to Figure 2a, a camera 30 is illustrated to be targeted on the surface 21 of the ellipsoid 20 e.g., Earth surface. The camera forward vector 32 is pointed towards a camera target point 25 on the surface 21 of the ellipsoid 20. The camera forward vector 32 is tilted with respect to normal 22 of the surface 21 of the ellipsoid 20. The camera tilt angle 33 is in this example marked with $\alpha$.

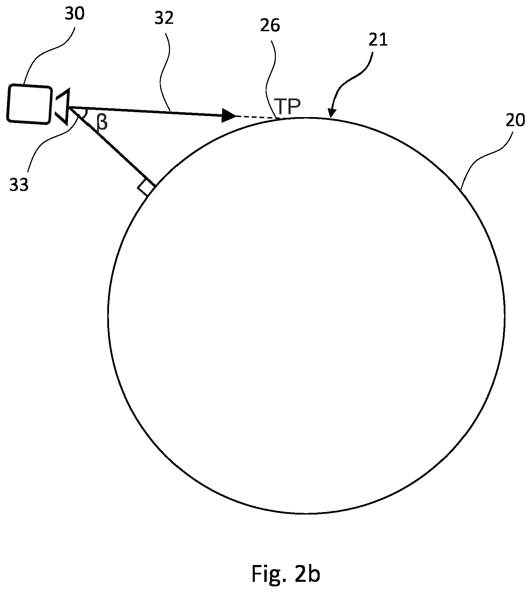

Referring to Figure 2b, the camera 30 is illustrated to be targeted on the surface 21 of the ellipsoid 20 in a different camera target point 26, which is approximately in the horizon when seen from the camera perspective. The camera forward vector 32 is pointed towards the camera target point 26 on the surface 21 of the ellipsoid 20. The camera tilt angle 33 is in this example larger and is marked with $\beta$.

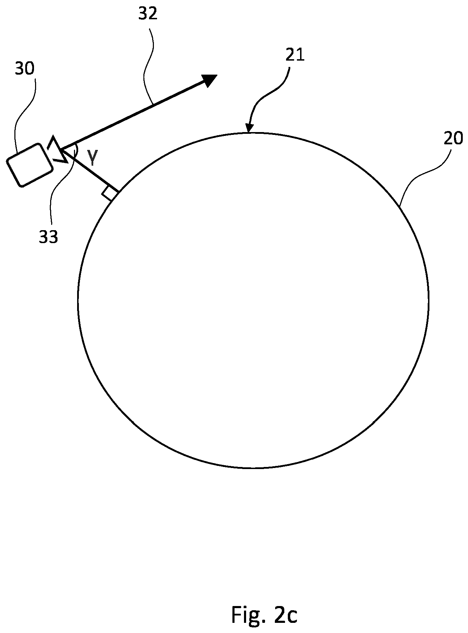

In Figure 2c the camera forward vector 32 is set to point over the horizon, so the camera forward vector 32 and the surface 21 of the ellipsoid 20 don't intersect. The camera tilt angle 33 is in the example even larger and is marked with $\gamma$. The camera target point would not be on the surface 21 of the ellipsoid 20 in this case, if the camera tilt angle would not be limited.

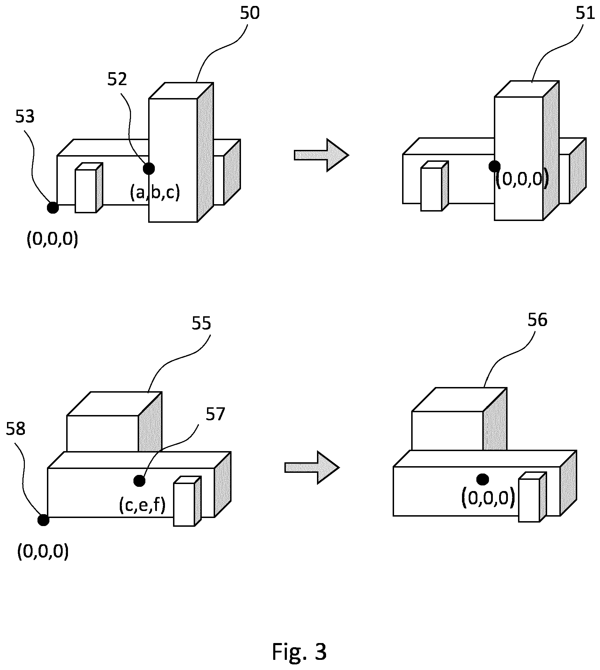

Referring to Figure 3 an example of translation is illustrated, where two 3D infrastructure design models 50, 55 in their planar cartesian coordinates are translated from their original position to the origin of their planar cartesian coordinates, correspondingly. Before translation, original centre-points 52, 57 of the 3D infrastructure design models 50, 55 correspondingly are stored for further use. The 3D infrastructure design model 50 is translated from coordinates (a, b, c) to origin (0,0,0) in the coordinate system of the 3D infrastructure design model 50. Correspondingly, the 3D infrastructure design model 55 is translated from coordinates (c, e, f) to origin (0,0,0) in the coordinate system of the 3D infrastructure design model 55. The translated 3D infrastructure design models 51, 56 are thus essentially centred around their corresponding origin in their coordinate systems.

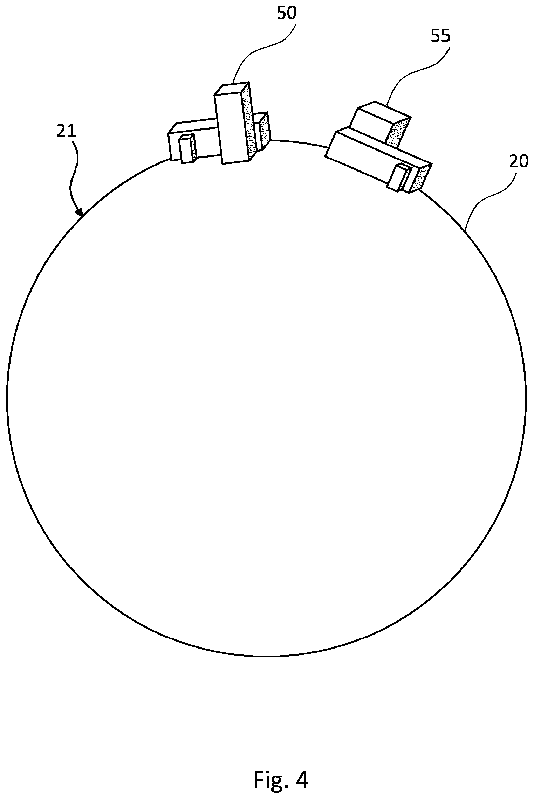

Referring to Figure 4, the 3D infrastructure design models 50, 55 are placed on the surface 21 on the ellipsoid 20. The size of the 3D infrastructure design models 50, 55 is strongly exaggerated with respect to the size of the ellipsoid 20 to exemplify the situation when the 3D infrastructure design models are placed on a curved surface such as a surface of an ellipsoid. The curvature of a surface of an ellipsoid poses a challenge when a 3D infrastructure design model with significant dimensions is placed on top of such a surface. This may be the case when a 3D infrastructure design model is e.g., part of infrastructure such as a street or a road or a long pipeline.

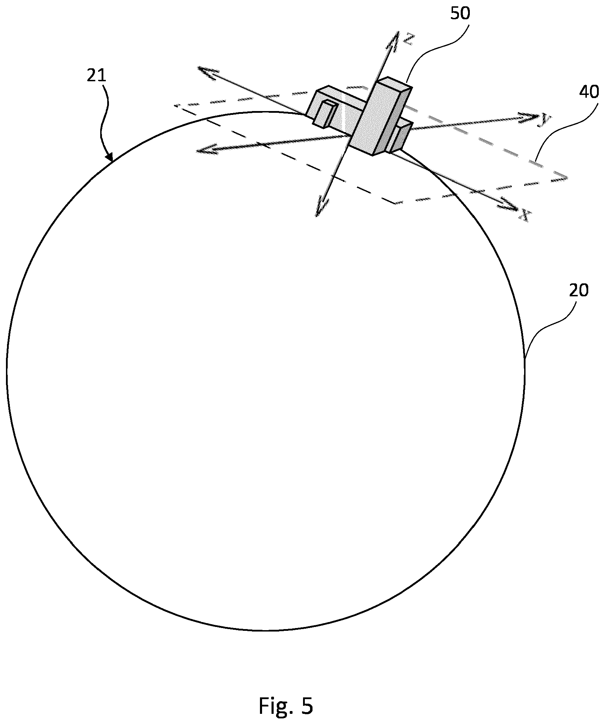

Figure 5 exemplifies placing a reference frame 40 placed at the centre-point of the 3D infrastructure design model 50 defined in the planar cartesian coordinates (x, y, z) is placed on top of the surface 21 of the ellipsoid 20. The reference frame 40 is oriented according to unit axes, which are calculated in Equation 1. Figures 3-5 also exemplify a plurality of 3D infrastructure design models which are translated, and which are placed on top of the surface 21 of the ellipsoid 20, and finally how a 3D infrastructure design model defined in the planar cartesian coordinates is placed on top of the surface 21 of the ellipsoid 20 for rendering. Before final rendering the 3D infrastructure design models are transformed on the ellipsoid using the reference frame and the original non-translated centre-points of said 3D infrastructure design models.

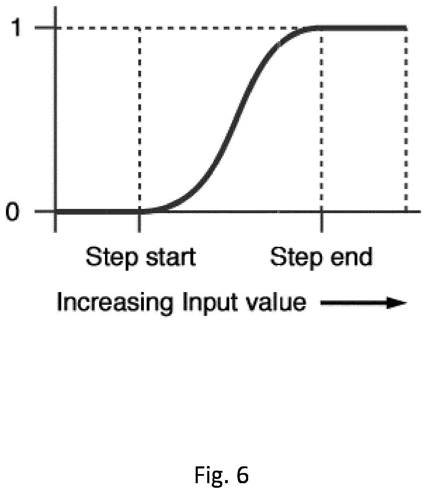

Figure 6 exemplifies an S-curve, which may be used to determine the camera target point so that a smooth transition from a view to the next view can be achieved. The S-curve may be e.g. a sigmoid function or smoothstep function or some other kind of function which provides a graceful and non-step-like transition from one level to another. The S-curve function has a zero gradient at both edges i.e. at the start of the step and at end of the step, and it changes smoothly towards the middle part of the slope between the start and the end of the step. This feature avoids sudden shifts in the camera orientation, when the orientation is changed, and the next camera target point is calculated as in Equations 2 and 3.

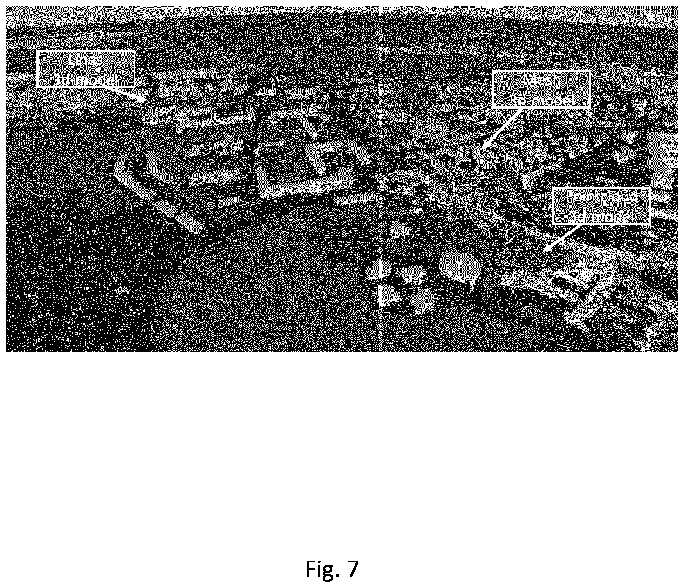

Figure 7 illustrates an example view of a terrain 60 of the earth. The curvature of the surface is exaggerated, which can be seen in the horizon. In figure 7, three example objects are placed on the surface of the terrain 60. A 3D infrastructure design model illustrating cabling channels 61, 3D infrastructure design models illustrating buildings 62 in a mesh and a 3D infrastructure design model illustrating a real view of a point cloud 63 exemplify objects of different kind, that may be designed or created with different tools or methodologies.

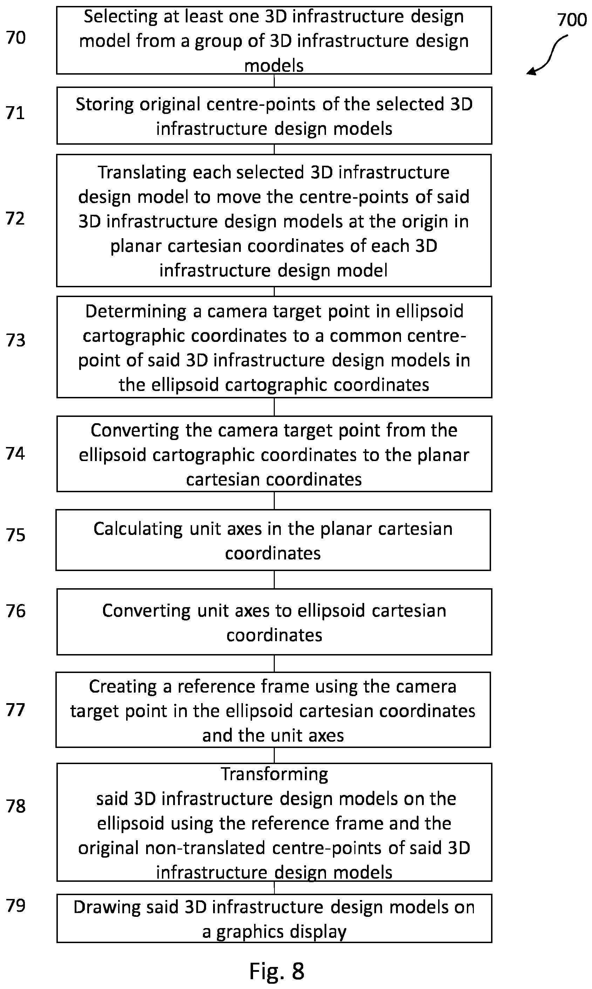

Figure 8 illustrates an embodiment of the invention for a method for visualising a 3D infrastructure design model in the planar coordinate system on an ellipsoid. In various embodiments, the operations of a method 700 may be performed e.g. by a computing apparatus 80. The operations of the method 700 may perform:

- in block 70, the computing apparatus 80 may select at least one 3D infrastructure design model from a group of 3D infrastructure design models for drawing on the graphic display or for a separate computing device and/or algorithm to generate an image. For example, the computing apparatus 80 may receive the 3D infrastructure design model data from a local memory (e.g. 82), a mass data storage (e.g., 83), a device connected to IO (e.g., 84), a network interface (e.g., 87), or other sources.
- in block 71, the computing apparatus 80 may store the original centre-points of the selected 3D infrastructure design models.
- in block 72, the computing apparatus 80 may translate said 3D infrastructure design models to move the centre-points of the said 3D infrastructure design models at the origin in the planar cartesian coordinates of said 3D infrastructure design models.
- in block 73, the computing apparatus 80 may determine the camera target point in the ellipsoid cartographic coordinates to the common centre-point of said 3D infrastructure design models in the ellipsoid coordinates
- in block 74, the computing apparatus 80 may convert camera target point from the ellipsoid cartographic coordinates to the planar cartesian coordinates.
- in block 75, the computing apparatus 80 may calculate unit axes in the planar coordinate system.
- in block 76, the computing apparatus 80 may convert unit axes to ellipsoid cartesian coordinates.
- in block 77, the computing apparatus 80 may create a reference frame using camera target point in the ellipsoid cartesian coordinates and unit axes.
- in block 78, the computing apparatus 80 may transform said 3D infrastructure design models on the ellipsoid using the reference frame and original non-translated centre-points of said 3D infrastructure design models.
- in block 79, the computing apparatus 80 may draw said 3D infrastructure design models on a graphics display.

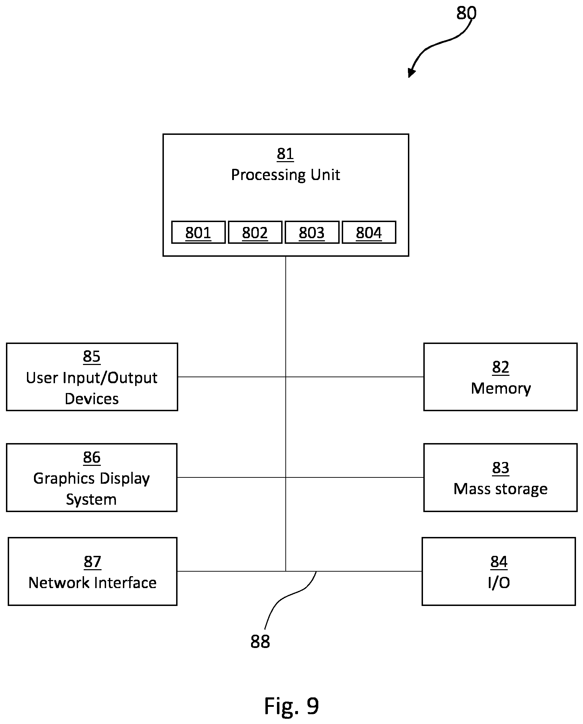

Figure 9 illustrates is a block diagram of the computing apparatus 80 suitable for use with the various embodiments. The computing apparatus 80 may be implemented as part of one or more computing systems, networks, servers, or combinations thereof. The computing apparatus 80 may comprise a processing unit 81, which may comprise various types of processors, for example, a graphics processor 801, an application processor 802, other coprocessors 803, 804, the memory 82, which are connected through a bus 88. A graphics display system 86 may also be coupled to a display that is part of one or more user input/output devices 85. Each processor 801, 802, 803, 804 may comprise one or more cores, and each processor/core may perform operations independent of the other processors/cores. Any of the processors 801, 802, 803, 804 may be configured to execute the methods described in various embodiments. The processor 801, 802, 803, 804 may include cache/internal memory sufficient to store the application software instructions. The internal memory may be a volatile or non-volatile memory, such as flash memory, or a mixture of both. The memory 82 may store, in part, instructions and data for execution by the processing unit 81 including program code used for various embodiments. The mass data storage 83 may comprise a magnetic disk drive, solid state drive, or an optical disk drive, is a non-volatile storage device for storing data and instructions for use by the processing unit 81. The mass data storage 83 stores the system software for implementing embodiments of the present disclosure for purposes of loading that software into the memory 82. The user input/output devices 85 may comprise an alphanumeric keypad, such as a keyboard, for inputting alphanumeric and other information, touch screen, or a pointing device, such as a mouse, or cursor direction keys, one or more microphones, and one or more speakers. The graphics display system 86 includes a display device that is configured to receive graphical information and the graphics display system 86 processes the information for output to the display device. The I/O 84 may include interfaces for computer support devices to add additional functionality to the computing apparatus 80. The network interface 87 may be included to connect the computing apparatus 80 to other data sources over local network, local computing centre, computing networks and data sources via internet. The components of the computing apparatus 80 may be illustrated as being connected via the bus 88, or via one or more data transport means.

It will be obvious to a person skilled in the art that, as the technology advances, the inventive concept can be implemented in various ways. The invention and its embodiments are not limited to the examples described above but may vary within the scope of the claims.

The computer program(s) may be in source code form, object code form, or in some intermediate form, and it may be stored in some sort of carrier, which may be any entity or device capable of carrying the program. Such carriers include transitory and/or non-transitory computer media, e.g., a record medium, computer memory, read-only memory, electrical carrier signal, telecommunications signal, and software distribution package. Depending on the processing power needed, the computer program may be executed in a single electronic digital processing unit, or it may be distributed amongst a number of processing units.

Even though the embodiments have been described above with reference to examples according to the accompanying drawings, it is clear that the embodiments are not restricted thereto but can be modified in several ways within the scope of the appended claims. Therefore, all words and expressions should be interpreted broadly, and they are intended to illustrate, not to restrict, the embodiment. It will be obvious to a person skilled in the art that, as technology advances, the inventive concept can be implemented in various ways. Further, it is clear to a person skilled in the art that the described embodiments may, but are not required to, be combined with other embodiments in various ways.

**Claims**

1. A computer implemented method (700) for visualising a 3D infrastructure model on an ellipsoid, comprising;

    selecting (70) at least one 3D infrastructure model from a group of 3D infrastructure models, wherein the at least one 3D infrastructure model is obtained from one of an infrastructure design tool and a building design tool, or is a point cloud captured with a 3D scanner, wherein the 3D infrastructure model is defined in planar coordinates;
    storing (71), by a processor of a computer, original centre-points of the selected 3D infrastructure models;
    translating (72), by the processor, said 3D infrastructure models to move the centre-points of said 3D infrastructure models at the origin in planar cartesian coordinates of said 3D infrastructure models, correspondingly;
    determining (73), by the processor, a camera target point (26) in ellipsoid cartographic coordinates to a common centre-point of said 3D infrastructure models in the ellipsoid cartographic coordinates; converting (74), by the processor, the camera target point (26) from the ellipsoid cartographic coordinates to the planar cartesian coordinates;
    calculating (75), by the processor, unit axes in the planar cartesian coordinates;
    converting (76), by the processor, the unit axes to the ellipsoid cartesian coordinates;
    creating (77), by the processor, a reference frame (40) using the camera target point (26) in the ellipsoid cartesian coordinates and the unit axes;
    transforming (78), by the processor, said 3D infrastructure models on the ellipsoid using the reference frame (40) and the original non-translated centre-points of said 3D models; and
    drawing (79), by the processor, said 3D infrastructure models on a graphics display.

2. A method according to claim 1 wherein the ellipsoid is a WGS84 ellipsoid.

3. A method according to any preceding claim wherein said camera target point (26) is calculated by interpolating between an intersection point of a camera forward vector (32) and the ellipsoid surface (21) and a previous camera target point depending on the camera tilt angle with respect to a normal of the ellipsoid surface (21) at a camera position.

4. A method according to any preceding claim wherein the determining of said camera target point (26) is done by calculating the intersection point of a camera forward vector (32) and the ellipsoid surface (21); and if the camera forward vector (32) does not intersect with the ellipsoid surface (21), then setting the camera target point (26) equal to the previous camera target point.

5. A method according to any preceding claim wherein the interpolation factor is corrected using a S-curve such as a sigmoid curve or a smoothstep curve.

6. An apparatus comprising a graphic display; at least one processor connected to the graphic display; and at least one memory including computer program code; the at least one memory and the computer program code configured to, with the at least one processor, cause the apparatus at least to perform: visualising at least one 3D infrastructure model on an ellipsoid, comprising means for;

   selecting (70) at least one 3D infrastructure model from a group of 3D infrastructure models, wherein the at least one 3D infrastructure model is obtained from one of an infrastructure design tool and a building design tool, or is a point cloud captured with a 3D scanner, wherein the 3D infrastructure model is defined in planar coordinates; storing (71) original centre-points of the selected 3D infrastructure models; translating (72) said 3D infrastructure models to move the centre-points of said 3D infrastructure models at the origin in planar cartesian coordinates of said 3D infrastructure models, correspondingly; determining (73) a camera target point (26) in ellipsoid cartographic coordinates to a common centre-point of said 3D infrastructure models in the ellipsoid cartographic coordinates; converting (74) the camera target point from the ellipsoid cartographic coordinates to planar cartesian coordinates; calculating (75) unit axes in the planar coordinate system; converting (76) the unit axes to the ellipsoid cartesian coordinates; creating (77) a reference frame (40) using the camera target point (26) in the ellipsoid cartesian coordinates and the unit axes; transforming (78) said 3D infrastructure models on the ellipsoid using the reference frame (40) and the original non-translated centre-points of said 3D models; and drawing (79) said 3D infrastructure models on a graphic display.

7. An apparatus according to claim 6 wherein the ellipsoid is a WGS84 ellipsoid.

8. An apparatus according to any of the claims 6-7 wherein the means for calculating the said camera target point (26) comprise interpolating said camera target point (26) between an intersection point of a camera forward vector (32) and the ellipsoid surface (21) and a previous camera target point depending on a camera tilt angle with respect to a normal of the ellipsoid surface (21) at a camera position.

9. An apparatus according to any of the claims 6-8 wherein the means for determining said camera target point (26) comprise calculating the intersection point of the camera forward vector (32) and the ellipsoid surface (21); and if the camera forward vector (32) does not intersect with the ellipsoid surface (21), then setting the camera target point (26) equal to the previous camera target point.

10. An apparatus according to any of the claims 6-9 comprising means to correct the camera tilt angle using a S-curve such as a sigmoid curve or a smoothstep curve.

11. A computer program comprising instructions stored thereon which, when the program is executed by a computer, cause the computer to carry out steps for visualising a 3D infrastructure model on an ellipsoid, comprising at least the following:

   selecting (70) at least one 3D infrastructure model from a group of 3D infrastructure models, wherein the at least one 3D infrastructure model is obtained from one of an infrastructure design tool and a building design tool, or is a point cloud captured with a 3D scanner, wherein the 3D infrastructure model is defined in planar coordinates; storing (71) original centre-points of the selected 3D infrastructure models; translating (72) said 3D infrastructure models to move the centre-points of the said 3D infrastructure models at the origin in planar cartesian coordinates of said 3D infrastructure models, correspondingly; determining (73) the camera target point in ellipsoid cartographic coordinates to a common centre-point of said 3D infrastructure models in the ellipsoid cartographic coordinates; converting (74) the camera target point from ellipsoid the cartographic coordinates to the planar cartesian coordinates; calculating (75) unit axes in the planar coordinate system; converting (76) the unit axes to ellipsoid cartesian coordinates; creating (77) a reference frame (40) using the camera target point (26) in the ellipsoid cartesian coordinates and the unit axes; transforming (78) said 3D infrastructure models on the ellipsoid using the reference frame and the original non-translated centre-points of said 3D infrastructure models; and drawing (79) said 3D infrastructure models on a graphic display.

12. A computer program according to claim 11 wherein the ellipsoid is a WGS84 ellipsoid.

13. A computer program according to any of the claims 11-12 wherein said camera target point (26) is calculated by interpolating between an intersection point of a camera forward vector (32) and the ellipsoid surface (21) and a previous camera target point depending on a camera tilt angle with respect to a normal of the ellipsoid surface (21) at a camera position.

14. A computer program according to any of the claims 11-13 wherein the determining of said camera target point (26) is done by calculating the intersection point of the camera forward vector (32) and the ellipsoid surface (21); and if the camera forward vector (32) does not intersect with the ellipsoid surface (21) , then setting the camera target point (26) equal to the previous camera target point.

15. A computer program according to claims 11-14 wherein the camera tilt angle is corrected using a S-curve such as a sigmoid curve or a smoothstep curve.

## Patentansprüche

1. Computerimplementiertes Verfahren (700) zur Visualisierung eines 3D-Infrastrukturmodells auf einem Ellipsoid, umfassend;

Auswählen (70) mindestens eines 3D-Infrastrukturmodells aus einer Gruppe von 3D-Infrastrukturmodellen, wobei das mindestens eine 3D-Infrastrukturmodell aus einem von einem Infrastruktur-Entwurfswerkzeug und einem Gebäudeentwurfswerkzeug erhalten wird, oder eine mit einem 3D-Scanner erfasste Punktwolke ist, wobei das 3D-Infrastrukturmodell in planaren Koordinaten definiert ist; Speichern (71), durch einen Prozessor eines Computers, ursprünglicher Mittelpunkte der ausgewählten 3D-Infrastrukturmodelle; Verschieben (72), durch den Prozessor, der 3D-Infrastrukturmodelle, um die Mittelpunkte der 3D-Infrastrukturmodelle in den Ursprung in planaren kartesischen Koordinaten der 3D-Infrastrukturmodelle zu bewegen, entsprechend; Bestimmen (73), durch den Prozessor, eines Kamerazielpunkts (26) in ellipsoidischen kartografischen Koordinaten zu einem gemeinsamen Mittelpunkt der 3D-Infrastrukturmodelle in den ellipsoidischen kartografischen Koordinaten; Umwandeln (74), durch den Prozessor, des Kamerazielpunkts (26) aus den ellipsoidischen kartografischen Koordinaten in die planaren kartesischen Koordinaten; Berechnen (75), durch den Prozessor, von Einheitsachsen in den planaren kartesischen Koordinaten; Umwandeln (76), durch den Prozessor, der Einheitsachsen in die ellipsoidischen kartesischen Koordinaten; Erzeugen (77), durch den Prozessor, eines Bezugssystems (40) unter Verwendung des Kamerazielpunkts (26) in den ellipsoidischen kartesischen Koordinaten und der Einheitsachsen; Transformieren (78), durch den Prozessor, der 3D-Infrastrukturmodelle auf das Ellipsoid unter Verwendung des Bezugssystems (40) und der ursprünglichen nicht verschobenen Mittelpunkte der 3D-Infrastrukturmodelle; und Darstellen (79), durch den Prozessor, der 3D-Infrastrukturmodelle auf einer Grafikanzeige.

2. Verfahren nach Anspruch 1, wobei das Ellipsoid ein WGS84-Ellipsoid ist.

3. Verfahren nach einem vorstehenden Anspruch, wobei der Kamerazielpunkt (26) durch Interpolieren zwischen einem Schnittpunkt eines Kamera-Vorwärtsvektors (32) und der Ellipsoidoberfläche (21) und einem vorherigen Kamerazielpunkt in Abhängigkeit von dem Kameraneigungswinkel in Bezug auf eine Normale der Ellipsoidoberfläche (21) an einer Kameraposition berechnet wird.

4. Verfahren nach einem vorstehenden Anspruch, wobei das Bestimmen des Kamerazielpunkts (26) durchgeführt wird durch Berechnen des Schnittpunkts eines Kamera-Vorwärtsvektors (32) und der Ellipsoidoberfläche (21); und wenn der Kamera-Vorwärtsvektor (32) nicht mit der Ellipsoidoberfläche (21) schneidet, dann Setzen des Kamerazielpunkts (26) gleich dem vorherigen Kamerazielpunkt.

5. Verfahren nach einem vorstehenden Anspruch, wobei der Interpolationsfaktor unter Verwendung einer S-Kurve wie einer Sigmoidkurve oder einer Smoothstep-Kurve korrigiert wird.

6. Einrichtung, umfassend eine Grafikanzeige; mindestens einen mit der Grafikanzeige geschalteten Prozessor; und mindestens einen Speicher einschließlich Computerprogrammcode; wobei der mindestens eine Speicher und der Computerprogrammcode dazu ausgebildet sind, zusammen mit dem mindestens einen Prozessor, die Einrichtung dazu veranlassen, mindestens Folgendes auszuführen:

Visualisieren mindestens eines 3D-Infrastrukturmodells auf einem Ellipsoid, umfassend Mittel zum Auswählen (70) mindestens eines 3D-Infrastrukturmodells aus einer Gruppe von 3D-Infrastrukturmodellen, wobei das mindestens eine 3D-Infrastrukturmodell aus einem von einem Infrastruktur-Entwurfswerkzeug und einem Gebäudeentwurfswerkzeug erhalten wird, oder eine mit einem 3D-Scanner erfasste Punktwolke ist, wobei das 3D-Infrastrukturmodell in planaren Koordinaten definiert ist; Speichern (71) ursprünglicher Mittelpunkte der ausgewählten 3D-Infrastrukturmodelle;
Verschieben (72) der 3D-Infrastrukturmodelle, um die Mittelpunkte der 3D-Infrastrukturmodelle in den Ursprung in planaren kartesischen Koordinaten der 3D-Infrastrukturmodelle zu bewegen, entsprechend;
Bestimmen (73) eines Kamerazielpunkts (26) in ellipsoidischen kartografischen Koordinaten zu einem gemeinsamen Mittelpunkt der 3D-Infrastrukturmodelle in den ellipsoidischen kartografischen Koordinaten; Umwandeln (74) des Kamerazielpunkts aus den ellipsoidischen kartografischen Koordinaten in planare kartesische Koordinaten;
Berechnen (75) von Einheitsachsen in dem planaren Koordinatensystem; Umwandeln (76) der Einheitsachsen in die ellipsoidischen kartesischen Koordinaten;
Erzeugen (77) eines Bezugssystems (40) unter Verwendung des Kamerazielpunkts (26) in den ellipsoidischen kartesischen Koordinaten und der Einheitsachsen;
Transformieren (78) der 3D-Infrastrukturmodelle auf das Ellipsoid unter Verwendung des Bezugssystems (40) und der ursprünglichen nicht verschobenen Mittelpunkte der 3D-Infrastrukturmodelle; und Darstellen (79) der 3D-Infrastrukturmodelle auf einer Grafikanzeige.

7. Einrichtung nach Anspruch 6, wobei das Ellipsoid ein WGS84-Ellipsoid ist.

8. Einrichtung nach einem der Ansprüche 6-7, wobei die Mittel zum Berechnen des genannten Kamerazielpunkts (26) das Interpolieren des genannten Kamerazielpunkts (26) zwischen einem Schnittpunkt eines Kamera-Vorwärtsvektors (32) und der Ellipsoidoberfläche (21) und einem vorherigen Kamerazielpunkt in Abhängigkeit von einem Kameraneigungswinkel in Bezug auf eine Normale der Ellipsoidoberfläche (21) an einer Kameraposition umfassen.

9. Einrichtung nach einem der Ansprüche 6-8, wobei die Mittel zum Bestimmen des Kamerazielpunkts (26) das Berechnen des Schnittpunkts des Kamera-Vorwärtsvektors (32) und der Ellipsoidoberfläche (21) umfassen; und wenn der Kamera-Vorwärtsvektor (32) nicht mit der Ellipsoidoberfläche (21) schneidet, dann Setzen des Kamerazielpunkts (26) gleich dem vorherigen Kamerazielpunkt.

10. Einrichtung nach einem der Ansprüche 6-9, umfassend Mittel zum Korrigieren des Kameraneigungswinkels unter Verwendung einer S-Kurve wie einer Sigmoidkurve oder einer Smoothstep-Kurve.

11. Computerprogramm, umfassend darauf gespeicherte Anweisungen, die, wenn das Programm von einem Computer ausgeführt wird, den Computer veranlassen, Schritte zur Visualisierung eines 3D-Infrastrukturmodells auf einem Ellipsoid auszuführen, die zumindest Folgendes umfassen:

Auswählen (70) mindestens eines 3D-Infrastrukturmodells aus einer Gruppe von 3D-Infrastrukturmodellen, wobei das mindestens eine 3D-Infrastrukturmodell aus einem von einem Infrastruktur-Entwurfswerkzeug und einem Gebäudeentwurfswerkzeug erhalten wird, oder eine mit einem 3D-Scanner erfasste Punktwolke ist, wobei das 3D-Infrastrukturmodell in planaren Koordinaten definiert ist;

Speichern (71) ursprünglicher Mittelpunkte der ausgewählten 3D-Infrastrukturmodelle;

Verschieben (72) der 3D-Infrastrukturmodelle, um die Mittelpunkte der 3D-Infrastrukturmodelle in den Ursprung in planaren kartesischen Koordinaten der 3D-Infrastrukturmodelle zu bewegen, entsprechend;

Bestimmen (73) des Kamerazielpunkts in ellipsoidischen kartografischen Koordinaten zu einem gemeinsamen Mittelpunkt der 3D-Infrastrukturmodelle in den ellipsoidischen kartografischen Koordinaten;

Umwandeln (74) des Kamerazielpunkts aus den ellipsoidischen kartografischen Koordinaten in die planaren kartesischen Koordinaten; Berechnen (75) von Einheitsachsen in dem planaren Koordinatensystem; Umwandeln (76) der Einheitsachsen in ellipsoidische kartesische Koordinaten;

Erzeugen (77) eines Bezugssystems (40) unter Verwendung des Kamerazielpunkts (26) in den ellipsoidischen kartesischen Koordinaten und der Einheitsachsen;

Transformieren (78) der 3D-Infrastrukturmodelle auf das Ellipsoid unter Verwendung des Bezugssystems und der ursprünglichen nicht verschobenen Mittelpunkte der 3D-Infrastrukturmodelle; und Darstellen (79) der 3D-Infrastrukturmodelle auf einer Grafikanzeige.

12. Computerprogramm nach Anspruch 11, wobei das Ellipsoid ein WGS84-Ellipsoid ist.

13. Computerprogramm nach einem der Ansprüche 11-12, wobei der Kamerazielpunkt (26) durch Interpolieren zwischen einem Schnittpunkt eines Kamera-Vorwärtsvektors (32) und der Ellipsoidoberfläche (21) und einem vorherigen Kamerazielpunkt in Abhängigkeit von einem Kameraneigungswinkel in Bezug auf eine Normale der Ellipsoidoberfläche (21) an einer Kameraposition berechnet wird.

14. Computerprogramm nach einem der Ansprüche 11-13, wobei das Bestimmen des Kamerazielpunkts (26) durchgeführt wird durch Berechnen des Schnittpunkts des Kamera-Vorwärtsvektors (32) und der Ellipsoidoberfläche (21); und wenn der Kamera-Vorwärtsvektor (32) nicht mit der Ellipsoidoberfläche (21) schneidet, dann Setzen des Kamerazielpunkts (26) gleich dem vorherigen Kamerazielpunkt.

15. Computerprogramm nach den Ansprüchen 11-14, wobei der Kameraneigungswinkel unter Verwendung einer S-Kurve wie einer Sigmoidkurve oder einer Smoothstep-Kurve korrigiert wird.

## Revendications

1. Procédé mis en œuvre par ordinateur (700) pour visualiser un modèle d'infrastructure 3D sur un ellipsoïde, comprenant ;

sélectionner (70) au moins un modèle d'infrastructure 3D à partir d'un groupe de modèles d'infrastructure 3D, dans lequel l'au moins un modèle d'infrastructure 3D est obtenu à partir d'un outil parmi un outil de conception d'infrastructure et un outil de conception de bâtiment, ou est un nuage de points capturé avec un scanner 3D, dans lequel le modèle d'infrastructure 3D est défini en coordonnées planes ;

stocker (71), par un processeur d'un ordinateur, des points centraux d'origine des modèles d'infrastructure 3D sélectionnés ;

traduire (72), par le processeur, lesdits modèles d'infrastructure 3D pour déplacer les points centraux desdits modèles d'infrastructure 3D à l'origine dans des coordonnées cartésiennes planes desdits modèles d'infrastructure 3D, de manière correspondante ;

déterminer (73), par le processeur, un point cible de caméra (26) dans des coordonnées cartographiques d'ellipsoïde vers un point central commun desdits modèles d'infrastructure 3D dans les coordonnées cartographiques d'ellipsoïde ;

convertir (74), par le processeur, le point cible de caméra (26) des coordonnées cartographiques d'ellipsoïde aux coordonnées cartésiennes planes ;

calculer (75), par le processeur, des axes unitaires dans les coordonnées cartésiennes planes ;

convertir (76), par le processeur, les axes unitaires en les coordonnées cartésiennes d'ellipsoïde ;

créer (77), par le processeur, un repère de référence (40) en utilisant le point cible de caméra (26) dans les coordonnées cartésiennes d'ellipsoïde et les axes unitaires ;

transformer (78), par le processeur, lesdits modèles d'infrastructure 3D sur l'ellipsoïde en utilisant le repère de référence (40) et les points centraux non traduits d'origine desdits modèles 3D ; et dessiner (79), par le processeur, lesdits modèles d'infrastructure 3D sur un écran graphique.

2. Procédé selon la revendication 1 dans lequel l'ellipsoïde est un ellipsoïde WGS84.

3. Procédé selon une revendication précédente quelconque dans lequel ledit point cible de caméra (26) est calculé par interpolation entre un point d'intersection d'un vecteur avant de caméra (32) et la surface d'ellipsoïde (21) et un point cible de caméra précédent, en fonction de l'angle d'inclinaison de caméra par rapport à une normale à la surface d'ellipsoïde (21) au niveau d'une position de caméra.

4. Procédé selon une revendication précédente quelconque dans lequel la détermination dudit point cible de caméra (26) est faite en calculant le point d'intersection d'un vecteur avant de caméra (32) et la surface d'ellipsoïde (21) ; et si le vecteur avant de caméra (32) ne coupe pas la surface d'ellipsoïde (21), alors le point cible de caméra (26) est défini comme étant égal au point cible de caméra précédent.

5. Procédé selon une revendication précédente quelconque dans lequel le facteur d'interpolation est corrigé en utilisant une courbe en S telle qu'une courbe sigmoïde ou une courbe à pas lisse.

6. Appareil comprenant un écran graphique ; au moins un processeur relié à l'écran graphique ; et au moins une mémoire incluant un code de programme informatique ; l'au moins une mémoire et le code de programme informatique sont configurés pour, avec l'au moins un processeur, amener l'appareil a moins à effectuer l'une des opérations suivantes :

visualiser au moins un modèle d'infrastructure 3D sur un ellipsoïde, comprenant des moyens pour ;
sélectionner (70) au moins un modèle d'infrastructure 3D à partir d'un groupe de modèles d'infrastructure 3D, dans lequel l'au moins un modèle d'infrastructure 3D est obtenu à partir d'un outil parmi un outil de conception d'infrastructure et un outil de conception de bâtiment, ou est un nuage de points capturé avec un scanner 3D, dans lequel le modèle d'infrastructure 3D est défini en coordonnées planes ;
stocker (71) des points centraux d'origine des modèles d'infrastructure 3D sélectionnés ;
traduire (72) lesdits modèles d'infrastructure 3D pour déplacer les points centraux desdits modèles d'infrastructure 3D à l'origine dans des coordonnées cartésiennes planes desdits modèles d'infrastructure 3D, de manière correspondante ;
déterminer (73) un point cible de caméra (26) dans des coordonnées cartographiques d'ellipsoïde vers un point central commun desdits modèles d'infrastructure 3D dans les coordonnées cartographiques d'ellipsoïde ;
convertir (74) le point cible de caméra des coordonnées cartographiques d'ellipsoïde à des coordonnées cartésiennes planes ;
calculer (75) des axes unitaires dans le système de coordonnées planes ;
convertir (76) les axes unitaires en les coordonnées cartésiennes d'ellipsoïde ;
créer (77) un repère de référence (40) en utilisant le point cible de caméra (26) dans les coordonnées cartésiennes d'ellipsoïde et les axes unitaires ;
transformer (78) lesdits modèles d'infrastructure 3D sur l'ellipsoïde en utilisant le repère de référence (40) et les points centraux non traduits d'origine desdits modèles 3D ; et
dessiner (79) lesdits modèles d'infrastructure 3D sur un écran graphique.

7. Appareil selon la revendication 6 dans lequel l'ellipsoïde est un ellipsoïde WGS84.

8. Appareil selon l'une quelconque des revendications 6 à 7 dans lequel les moyens pour calculer ledit point cible de caméra (26) comprennent une interpolation dudit point cible de caméra (26) entre un point d'intersection d'un vecteur avant de caméra (32) et la surface d'ellipsoïde (21) et un point cible de caméra précédent, en fonction d'un angle d'inclinaison de caméra par rapport à une normale à la surface d'ellipsoïde (21) au niveau d'une position de caméra.

9. Appareil selon l'une quelconque des revendications 6 à 8 dans lequel les moyens pour déterminer ledit point cible de caméra (26) comprennent un calcul du point d'intersection du vecteur avant de caméra (32) et la surface d'ellipsoïde (21) ; et si le vecteur avant de caméra (32) ne coupe pas la surface d'ellipsoïde (21), alors le point cible de caméra (26) est défini comme étant égal au point cible de caméra précédent.

10. Appareil selon l'une quelconque des revendications 6 à 9 comprenant des moyens pour corriger l'angle d'inclinaison de caméra en utilisant une courbe en S telle qu'une courbe sigmoïde ou une courbe à pas lisse.

11. Programme informatique comprenant des instructions stockées sur celui-ci qui, lorsque le programme est exécuté par un ordinateur, amènent l'ordinateur à effectuer des étapes pour visualiser un modèle d'infrastructure 3D sur un ellipsoïde, comprenant au moins les opérations suivantes :

sélectionner (70) au moins un modèle d'infrastructure 3D à partir d'un groupe de modèles d'infrastructure 3D, dans lequel l'au moins un modèle d'infrastructure 3D est obtenu à partir d'un outil parmi un outil de conception d'infrastructure et un outil de conception de bâtiment, ou est un nuage de points capturé avec un scanner 3D, dans lequel le modèle d'infrastructure 3D est défini en coordonnées planes ;

stocker (71) des points centraux d'origine des modèles d'infrastructure 3D sélectionnés ;

traduire (72) lesdits modèles d'infrastructure 3D pour déplacer les points centraux desdits modèles d'infrastructure 3D à l'origine dans des coordonnées cartésiennes planes desdits modèles d'infrastructure 3D, de manière correspondante ;

déterminer (73) le point cible de caméra dans des coordonnées cartographiques d'ellipsoïde vers un point central commun desdits modèles d'infrastructure 3D dans les coordonnées cartographiques d'ellipsoïde ;

convertir (74) le point cible de caméra des coordonnées cartographiques d'ellipsoïde aux coordonnées cartésiennes planes ;

calculer (75) des axes unitaires dans le système de coordonnées planes ;

convertir (76) les axes unitaires en coordonnées cartésiennes d'ellipsoïde ;

créer (77) un repère de référence (40) en utilisant le point cible de caméra (26) dans les coordonnées cartésiennes d'ellipsoïde et les axes unitaires ;

transformer (78) lesdits modèles d'infrastructure 3D sur l'ellipsoïde en utilisant le repère de référence et les points centraux non traduits d'origine desdits modèles d'infrastructure 3D ; et

dessiner (79) lesdits modèles d'infrastructure 3D sur un écran graphique.

12. Programme informatique selon la revendication 11 dans lequel l'ellipsoïde est un ellipsoïde WGS84.

13. Programme informatique selon les revendications 11 à 12 dans lequel ledit point cible de caméra (26) est calculé par interpolation entre un point d'intersection d'un vecteur avant de caméra (32) et la surface d'ellipsoïde (21) et un point cible de caméra précédent, en fonction d'un angle d'inclinaison de caméra par rapport à une normale à la surface d'ellipsoïde (21) au niveau d'une position de caméra.

14. Programme informatique selon les revendications 11 à 13 dans lequel la détermination dudit point cible de caméra (26) est faite en calculant le point d'intersection d'un vecteur avant de caméra (32) et la surface d'ellipsoïde (21) ; et si le vecteur avant de caméra (32) ne coupe pas la surface d'ellipsoïde (21), alors le point cible de caméra (26) est défini comme étant égal au point cible de caméra précédent.

15. Programme informatique selon les revendications 11 à 14 dans lequel l'angle d'inclinaison de caméra est corrigé en utilisant une courbe en S telle qu'une courbe sigmoïde ou une courbe à pas lisse.

Fig. 1a

Fig. 1b

Fig. 1c

Fig. 2a

Fig. 2b

Fig. 2c

Fig. 3

Fig. 4

Fig. 5

Fig. 6

Fig. 7

700

| 70 | Selecting at least one 3D infrastructure design model from a group of 3D infrastructure design models |
|---|---|
| 71 | Storing original centre-points of the selected 3D infrastructure design models |
| 72 | Translating each selected 3D infrastructure design model to move the centre-points of said 3D infrastructure design models at the origin in planar cartesian coordinates of each 3D infrastructure design model |
| 73 | Determining a camera target point in ellipsoid cartographic coordinates to a common centre-point of said 3D infrastructure design models in the ellipsoid cartographic coordinates |
| 74 | Converting the camera target point from the ellipsoid cartographic coordinates to the planar cartesian coordinates |
| 75 | Calculating unit axes in the planar cartesian coordinates |
| 76 | Converting unit axes to ellipsoid cartesian coordinates |
| 77 | Creating a reference frame using the camera target point in the ellipsoid cartesian coordinates and the unit axes |
| 78 | Transforming said 3D infrastructure design models on the ellipsoid using the reference frame and the original non-translated centre-points of said 3D infrastructure design models |
| 79 | Drawing said 3D infrastructure design models on a graphics display |

Fig. 8

80

```
┌─────────────────────────────────────┐
│              81                      │
│        Processing Unit               │
│                                      │
│   ┌────┐┌────┐┌────┐┌────┐           │
│   │801 ││802 ││803 ││804 │           │
│   └────┘└────┘└────┘└────┘           │
└─────────────────────────────────────┘
```

```
┌───────────────────┐              ┌───────────────────┐
│        85         │              │        82         │
│  User Input/Output│              │     Memory        │
│      Devices      │              │                   │
└───────────────────┘              └───────────────────┘

┌───────────────────┐              ┌───────────────────┐
│        86         │              │        83         │
│  Graphics Display │              │   Mass storage    │
│      System       │              │                   │
└───────────────────┘              └───────────────────┘

┌───────────────────┐              ┌───────────────────┐
│        87         │              │        84         │
│ Network Interface │              │       I/O         │
└───────────────────┘              └───────────────────┘
```

88

Fig. 9

**EP 4 290 463 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2022076503 A1